# EUROPÄISCHE PATENTANMELDUNG

(11) **EP 3 640 655 A1**
(43) Veröffentlichungstag der Anmeldung: **22.04.2020**
(21) Anmeldenummer: 19201060.1
(22) Anmeldetag: 02.10.2019
(51) Int. Cl.: G01R 31/364

(54) **BATTERIESENSOR UND VERFAHREN ZUR HERSTELLUNG EINES BATTERIESENSORS**

(30) Priorität: 12.10.2018 DE 102018217554
(71) Anmelder: Continental Automotive GmbH, 30165 Hannover (DE)
(72) Erfinder: Frenzel, Henryk - c/o Continental Teves AG & Co. OHG, 60488 Frankfurt am Main (DE)

(57) **Zusammenfassung**

Die Erfindung betrifft einen Batteriesensor (10), insbesondere für eine Fahrzeugbatterie, mit zwei Leitungsabschnitten (12, 16), einem zwischen den Leitungsabschnitten (12, 16) angeordneten Messwiderstand (20), einer Spannungserfassungseinrichtung zur Erfassung eines Spannungsabfalls über den Messwiderstand (20) und einem Gehäuse (22), das den Messwiderstand (20), die Spannungserfassungseinrichtung und die Leitungsabschnitte (12, 16) zumindest abschnittsweise umschließt. An zumindest einem der Leitungsabschnitte (12, 16) und/oder am Messwiderstand (20) ist zumindest ein Halteabschnitt (32, 34) vorgesehen ist, in den das Gehäuse (22) formschlüssig eingreift und eine formschlüssige Verbindung zwischen dem zumindest einen Halteabschnitt (32, 34) und dem Gehäuse (22) herstellt.

Die Erfindung betrifft des Weiteren ein Verfahren zur Herstellung eines solchen Batteriesensors (10)

## Beschreibung

Die Erfindung betrifft einen Batteriesensor, insbesondere für eine Fahrzeugbatterie, mit zwei Leitungsabschnitte, einem zwischen den Leitungsabschnitten angeordneten Messwiderstand, einer Spannungserfassungseinrichtung zur Erfassung eines Spannungsabfalls über den Messwiderstand sowie mit einem Gehäuse, das den Messwiderstand, die Spannungserfassungseinrichtung und die Leitungsabschnitte zumindest abschnittsweise umschließt.

Batteriesensoren werden in Fahrzeugen zur Erfassung von Batterieparametern der Fahrzeugbatterie verwendet, um Aussagen über den Ladezustand und/oder den Gesundheitszustand der Batterie treffen zu können. Die zu erfassenden Batterieparameter sind beispielsweise die Batteriespannung, der Batteriestrom und die Temperatur der Batterie, wobei insbesondere die Batteriespannung und der Batteriestrom permanent erfasst werden müssen, um eine exakte Aussage über den Ladezustand der Batterie treffen zu können.

Der Batteriesensor ist üblicherweise an einem der Batteriepole angeordnet und weist beispielsweise eine Polklemme zur Kontaktierung mit der Fahrzeugbatterie auf. Des Weiteren weist der Batteriesensor einen Anschluss für ein Kabel, beispielsweise ein Massekabel, auf.

Zur Erfassung des Batteriestroms ist ein im Strompfad des Batteriestroms angeordneter Messwiderstand vorgesehen, der zwei Leitungsabschnitte, die mit der Polklemme und dem Anschluss zum Fahrzeugchassis kontaktiert sind, elektrisch miteinander verbindet. Des Weiteren ist eine Spannungserfassungseinrichtung zur Erfassung einer über den Messwiderstand abfallenden Spannung vorgesehen. Ist der elektrische Widerstand des Messwiderstandes bekannt, kann aus dem erfassten Spannungsabfall über den Messwiderstand der über den Messwiderstand, also den Batteriesensor, fließende Strom berechnet werden.

Aufgrund der Einbausituation in einem Fahrzeug, insbesondere in einer Polnische einer Fahrzeugbatterie, muss der Batteriesensor sehr kompakt ausgebildet sein. Darüber hinaus werden an den Batteriesensor hohe Anforderungen bezüglich der mechanischen Stabilität gestellt. Insbesondere durch das am Anschluss des Batteriesensors angeschlossene Kabel wirken auf den Batteriesensor hohe Kräfte, insbesondere Zugkräfte.

Aufgabe der Erfindung ist es, einen Batteriesensor bereitzustellen, die eine sehr kompakte Bauform aufweist und eine ausreichende Stabilität für die im Fahrzeugbetrieb auftretenden Belastungen aufweist.

Zur Lösung der Aufgabe bei einem Batteriesensor, insbesondere für eine Fahrzeugbatterie, vorgesehen, mit zwei Leitungsabschnitte, einem zwischen den Leitungsabschnitten angeordneten Messwiderstand, einer Spannungserfassungseinrichtung zur Erfassung eines Spannungsabfalls über den Messwiderstand sowie mit einem Gehäuse, das den Messwiderstand, die Spannungserfassungseinrichtung und zumindest abschnittsweise die Leitungsabschnitte umschließt. An zumindest einem der Leitungsabschnitte und/oder am Messwiderstand ist zumindest ein Halteabschnitt vorgesehen, in den das Gehäuse formschlüssig eingreift und eine formschlüssige Verbindung zwischen dem zumindest einen Halteabschnitt und dem Gehäuse herstellt.

Durch den Formschluss zwischen dem Gehäuse und dem Leitungsabschnitt bzw. dem Messwiderstand ist eine wesentlich bessere Aufnahme von Zugkräften möglich. Insbesondere kann so die Belastung auf andere Bauteile des Batteriesensors, beispielsweise die Spannungserfassungseinrichtung oder eine Auswerteschaltung, reduziert werden.

Der zumindest eine Halteabschnitt kann beispielsweise durch eine Vertiefung, eine Prägung und/oder eine Aussparung gebildet sein. Der Halteabschnitt kann beispielsweise nach der Herstellung des Leitungsabschnitts und des Messwiderstandes hergestellt bzw. eingebracht werden. Beispielsweise können die Leitungsabschnitte zuerst mit dem Messwiderstand verbunden, beispielsweise mit diesem verschweißt, werden und anschließend wird der Halteabschnitt durch Prägen eingebracht. Der Halteabschnitt kann aber auch bereits vor dem Verbinden der Leitungsabschnitte mit dem Messwiderstand eingebracht werden.

Vorzugsweise entspricht die Größe der Querschnittsfläche des Leitungsabschnitts und/oder des Messwiderstandes im Bereich des zumindest einen Halteabschnitts zumindest der Größe der Querschnittsfläche in einem Bereich unmittelbar vor und/oder hinter dem Halteabschnitt. Eine durch den Halteabschnitt hervorgerufene Querschnittsreduzierung könnte zu einer Erhöhung des elektrischen Widerstandes oder zur einer lokalen Erhöhung der Stromdichte führen. Um dies zu verhindern, ist vorgesehen, dass der Querschnitt des Batteriesensors konstant ist bzw. so gewählt ist, dass durch den Halteabschnitt keine negative Beeinflussung des Stromflusses erfolgt.

Optional kann der Halteabschnitt auch in einem Randbereich des Leitungsabschnitts und/oder des Messwiderstandes vorgesehen sein. Beispielsweise kann der der Leitungsabschnitt so dimensioniert sein, dass der Halteabschnitt außerhalb eines für den Stromfluss relevanten Bereichs angeordnet ist, sodass durch den Halteabschnitt keine oder nur eine geringe Beeinflussung des Stromflusses erfolgt.

Das Gehäuse kann beispielsweise aus einem Kunststoff bestehen und an die Leitungsabschnitte und/oder den Messwiderstand angespritzt werden. Durch ein Spritzgussverfahren fließt das Kunststoffmaterial während der Herstellung des Gehäuses in die Halteabschnitte hinein, sodass auf einfache Weise eine formschlüssige Verbindung zwischen dem Gehäuse und den Halteabschnitten hergestellt werden kann.

Optional ist es auch möglich, dass das Gehäuse zumindest abschnittsweise mit den Leitungsabschnitten und/oder dem Messwiderstand verklebt ist. Der Klebstoff kann sich dabei beispielsweise ebenfalls in die Halteabschnitte erstrecken, wodurch ein Formschluss hergestellt werden kann.

Zur Lösung der Aufgabe ist des Weiteren ein Verfahren zur Herstellung eines Batteriesensors nach einem der vorhergehenden Ansprüche vorgesehen. Das Verfahren weist die folgenden Schritte auf:
- Bereitstellen einer Baugruppe bestehend aus zumindest den Leitungsabschnitten und dem mit den Leitungsabschnitten elektrisch verbundenen Messwiderstand, wobei zumindest an den Leitungsabschnitten und/oder dem Messwiderstand zumindest ein Halteabschnitt vorgesehen ist,
- Verbinden der Baugruppe mit dem Gehäuse, wobei das Gehäuse formschlüssig in die Halteabschnitte eingreift.

Vorzugsweise wird das Gehäuse an die Baugruppe angespritzt, insbesondere aus Kunststoff.

Der zumindest eine Halteabschnitt wird vorzugsweise durch Umformen, insbesondere durch Prägen, hergestellt. Insbesondere wird der Halteabschnitt vor dem Herstellen des Gehäuses hergestellt.

Weitere Vorteile und Merkmale ergeben sich aus der nachfolgenden Beschreibung in Verbindung mit den beigefügten Zeichnungen. In diesen zeigen:
- Figur 1: eine perspektivische Ansicht eines erfindungsgemäßen Batteriesensors;
- Figur 2: eine Draufsicht auf den Batteriesensor aus Figur 1;
- Figur 3a: eine erste Darstellung eines Halteabschnitts des Batteriesensors aus den Figuren 1 und 2;
- Figur 3b: eine zweite Darstellung eines Halteabschnitts des Batteriesensors aus den Figuren 1 und 2;
- Figur 4: eine Draufsicht auf eine zweite Ausführungsform eines erfindungsgemäßen Batteriesensors; und
- Figur 5: eine Detailansicht des Batteriesensors aus Figur 4.

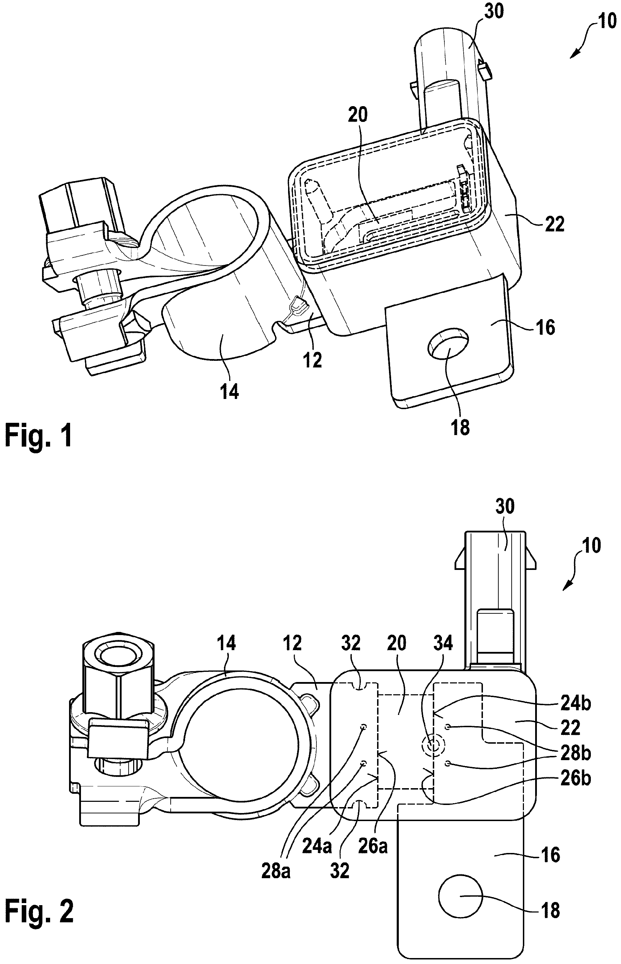

In den Figuren 1 und 2 ist ein Batteriesensor 10 zur Erfassung von Batteriewerten, insbesondere von einer Fahrzeugbatterie in einem Fahrzeug, gezeigt. Der Batteriesensor 10 kann beispielsweise die Batteriespannung, den Batteriestrom und/oder die Batterietemperatur erfassen. Mit diesem Batteriekennwerten können beispielsweise Aussagen über den Gesundheitszustand und/oder den Ladungszustand der Batterie getroffen werden.

Der Batteriesensor 10 hat einen ersten Leitungsabschnitt 12, der mit einer Polklemme 14 gebunden ist, sowie einen zweiten Leitungsabschnitt 16 mit einem Anschluss 18 zum Anschließen eines Kabels, beispielsweise eines Massekabels. Die Leitungsabschnitte 12, 16 sind über einen Messwiderstand 20 elektrisch miteinander verbunden.

Der Messwiderstand 20 weist einen bekannten elektrischen Widerstand auf. Beispielsweise besteht der Messwiderstand 20 aus einer Kupfer-Nickel-Mangan-Legierung, die eine geringe Temperaturabhängigkeit des elektrischen Widerstandes aufweist. Alternativ kann der Messwiderstand aus einem anderen für einen Messwiderstand geeigneten Material bestehen, beispielsweise Kupfer oder eine Kupferlegierung. Weist das Material eine höhere Temperaturabhängigkeit des elektrischen Widerstandes auf, ist diese Temperaturabhängigkeit vorzugsweise vorab ermittelt, sodass der elektrische Widerstand in Abhängigkeit von der Temperatur des Messwiderstandes 20 genau bestimmt werden kann. Alternativ wird im laufenden Betrieb des Batteriesensors regelmäßig der aktuelle elektrische Widerstand oder ein Korrekturwert für den elektrischen Widerstand bestimmt.

Der Messwiderstand 20 ist jeweils mit einer Kontaktfläche 24a, 24b elektrisch leitend mit jeweils einer Fügefläche 26a, 26b der Leitungsabschnitte 12, 16 verbunden.

Des Weiteren ist ein Gehäuse 22 vorgesehen, das den Messwiderstand 20 sowie zumindest abschnittsweise die Leitungsabschnitte 12, 16 einschließt.

Im Gehäuse 22 ist des Weiteren eine hier nicht im Detail dargestellte Auswerteeinheit zur Auswertung der mit dem Batteriesensor 10 erfassten Batteriewerte vorgesehen. Die Auswerteeinheit umfasst beispielsweise eine Spannungserfassungseinrichtung zur Erfassung eines Spannungsabfalls über den Messwiderstand 20. Die Spannungserfassungseinrichtung ist mit Kontaktstellen 28a, 28b vor und hinter dem Messwiderstand 20 kontaktiert. Aus dem erfassten Spannungsabfall über den Messwiderstand 20 sowie dem bekannten elektrischen Widerstand des Messwiderstandes 20 kann der über den Batteriesensor fließende Strom berechnet werden.

Zusätzlich kann der Batteriesensor hier nicht im Detail gezeigte Spannungsmesseinrichtungen zur Erfassung der Batteriespannung sowie Temperaturmesseinrichtungen zur Erfassung der Batterietemperatur aufweisen.

Das Gehäuse weist des Weiteren einen Steckanschluss 30 zur Kontaktierung der Auswerteeinheit mit einer Fahrzeugsteuerung auf.

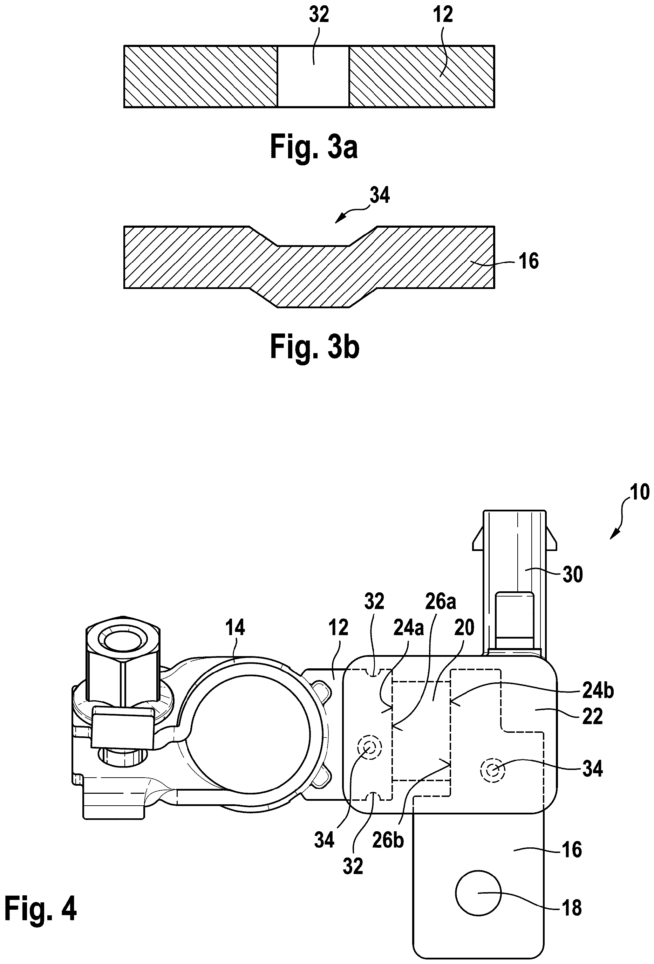

Wie insbesondere in Figur 1 zu sehen ist, sind am ersten Leitungsabschnitt seitliche Aussparungen vorgesehen, die, wie nachfolgend erläutert wird, erste Halteabschnitte 32 bilden. Des Weiteren ist am zweiten Leitungsabschnitt 16 bzw. am Messwiderstand 20 eine Prägung vorgesehen, die einen zweiten Halteabschnitt 34 bildet. Der erste Halteabschnitt 34 ist durch ein Umformverfahren in den zweiten Leitungsabschnitt 16 bzw. den Messwiderstand 20 eingebracht (siehe auch Figur 3b).

Bei der Herstellung des Batteriesensors 10 wird zunächst die Baugruppe bestehend aus den Leitungsabschnitte 12, 16 und dem Messwiderstand 20 bereitgestellt. Beispielsweise werden in einem ersten Herstellungsschritt die Leitungsabschnitte 12, 16 mit dem Messwiderstand 20 verbunden, beispielsweise durch ein Schweiß- oder Lötverfahren. Anschließend werden die Spannungserfassungseinrichtung, die Auswerteschaltung sowie optional weitere Messeinrichtungen oder Sensoren mit dem Messwiderstand 20 und/oder den Leitungsabschnitte 12, 16 verbunden oder miteinander kontaktiert. Anschließend wird das Gehäuse hergestellt, beispielsweise an die Leitungsabschnitte 12, 16 und den Messwiderstand 20 angespritzt, wobei weitere Bauteile, beispielsweise die Spannungserfassungseinrichtung und die Auswerteschaltung vom Kunststoffmaterial umspritzt werden.

Das Kunststoffmaterial füllt des Weiteren die Halteabschnitte 32,34, sodass nach dem Aushärten des Kunststoffmaterial eine formschlüssige Verbindung zwischen der Baugruppe bestehend aus den Leitungsabschnitten 12, 16 und dem Messwiderstand 20 hergestellt ist. Auf den Batteriesensor 10 wirkende Kräfte, beispielsweise Zugkräfte am Anschluss 18, werden über den Formschluss zwischen den Leitungsabschnitten 12, 16 und dem Gehäuse 22 abgefangen, sodass die mechanischen Belastungen auf den Messwiderstand 20 sowie weitere Bauteile des Batteriesensors 10 deutlich reduziert werden können. Der Batteriesensor 10 weist eine deutlich höhere Stabilität gegenüber mechanischen Belastungen auf. Um den Formschluss herzustellen, sind keine zusätzlichen Herstellungsschritte erforderlich. Der Formschluss wird beim Herstellen des Gehäuses, insbesondere durch anspritzen, hergestellt.

Wie in den Figuren 1 und 2 zu sehen ist, sind sowohl am ersten Leitungsabschnitt 12 wie auch am zweiten Leitungsabschnitt 16 Halteabschnitte 32, 34 vorgesehen. Dadurch können auf den Batteriesensor 10 wirkende Belastungen, insbesondere Zugbelastungen auf die Leitungsabschnitte 12, 16, zuverlässig vom Gehäuse 22aufgenommen und der Messwiderstand 20 vor Belastungen geschützt werden.

Die Position und die Art der Halteabschnitte 32,34 kann beliebig angepasst werden, insbesondere in Abhängigkeit von den im Fahrzeug auftretenden Belastungen. Vorzugsweise sind zumindest ein erster Halteabschnitt 32 am ersten Leitungsabschnitt 12 sowie zumindest ein zweiter Halteabschnitt 34 am zweiten Leitungsabschnitt 16 vorgesehen, wobei die Halteabschnitte 32, 34 so angeordnet sind, dass mechanische Belastungen auf den Messwiderstand 20 sowie elektronische Bauteile des Batteriesensors 10 durch den Formschluss der Halteabschnitte 32, 34 mit dem Gehäuse 22 reduziert werden.

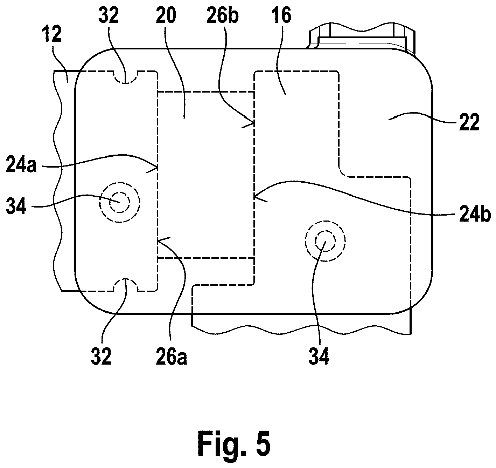

In den Figuren 4 und 5 sind beispielswiese an beiden Leitungsabschnitten durch Prägungen gebildete Halteabschnitte 32, 34 vorgesehen.

Die Halteabschnitte 32, 34 können zudem auf beliebige Weise ausgebildet sein, die einen Formschluss mit dem Gehäuse 22 ermöglicht. Die Ausbildung der Halteabschnitt der 32, 34 als Prägung hat den Vorteil, dass die Querschnittsfläche weitgehend unverändert bleibt, sodass durch das Einbringen der Prägung der Stromfluss nicht oder nur geringfügig beeinflusst wird. Alternativ können die Leitungsabschnitte 12, 16 und der Messwiderstand 20 so ausgebildet sein, dass auch bei einem einbringen eines Halteabschnitts 32, 34 der Stromfluss nicht oder nur geringfügig beeinflusst wird. Dies kann beispielsweise dadurch erfolgen, dass die Querschnittsfläche im Bereich des Halteabschnitts 32, 34 vergrößert ist, sodass die Querschnittsfläche nach dem Einbringen des Halteabschnitts 32, 34 ausreichend groß ist. Die Halteabschnitte 32, 34 können auch so eingebracht werden, dass diese nicht im direkten Stromfluss liegen (siehe beispielsweise Halteabschnitt der 34 in Figur 1) .

Die Halteabschnitte 32, 34 können auf beliebige Weise eingebracht werden, wobei der Stromfluss nicht oder nur geringfügig beeinflusst werden soll. Dies kann beispielsweise durch Einkerbungen, Prägungen oder durch das Bilden von Aussparungen am Rand oder in der Mitte der Leitungsabschnitte 12, 16 und/oder der Messwiderstand 20 erfolgen.

### Bezugszeichenliste

- 10: Batteriesensor
- 12: erster Leitungsabschnitt
- 14: Polklemme
- 16: zweiter Leitungsabschnitt
- 18: Anschluss
- 20: Messwiderstand
- 22: Gehäuse
- 24a: Kontaktfläche
- 24b: Kontaktfläche
- 26a: Fügefläche
- 26b: Fügefläche
- 28a: Kontaktstelle
- 28b: Kontaktstelle
- 30: Steckanschluss
- 32: erster Halteabschnitt
- 34: zweiter Halteabschnitt

## Patentansprüche

1. Batteriesensor (10), insbesondere für eine Fahrzeugbatterie, mit zwei Leitungsabschnitten (12, 16), einem zwischen den Leitungsabschnitten (12, 16) angeordneten Messwiderstand (20), einer Spannungserfassungseinrichtung zur Erfassung eines Spannungsabfalls über den Messwiderstand (20) und einem Gehäuse (22), das den Messwiderstand (20), die Spannungserfassungseinrichtung und die Leitungsabschnitte (12, 16) zumindest abschnittsweise umschließt, **dadurch gekennzeichnet, dass** an zumindest einem der Leitungsabschnitte (12, 16) und/oder am Messwiderstand (20) zumindest ein Halteabschnitt (32, 34) vorgesehen ist, in den das Gehäuse (22) formschlüssig eingreift und eine formschlüssige Verbindung zwischen dem zumindest einen Halteabschnitt (32, 34) und dem Gehäuse (22) herstellt.

2. Batteriesensor nach Anspruch 1, **dadurch gekennzeichnet, dass** der zumindest eine Halteabschnitt (32, 34) durch eine Vertiefung, eine Prägung und/oder eine Aussparung gebildet ist.

3. Batteriesensor, nach einem der Ansprüche 1 und 2, **dadurch gekennzeichnet, dass** die Größe der Querschnittsfläche des Leitungsabschnitts (12, 16) und/oder des Messwiderstandes (20) im Bereich des zumindest einen Halteabschnitts zumindest der Größe der Querschnittsfläche in einem Bereich unmittelbar vor und/oder hinter dem Halteabschnitt (32, 34) entspricht.

4. Batteriesensor nach einem der vorhergehenden Ansprüche, **dadurch gekennzeichnet, dass** der zumindest eine Halteabschnitt (32, 34) in einem Randbereich des Leitungsabschnitts vorgesehen ist.

5. Batteriesensor nach einem der vorhergehenden Ansprüche, **dadurch gekennzeichnet, dass** das Gehäuse (22) aus einem Kunststoff besteht und insbesondere an zumindest die Leitungsabschnitte (12, 16) angespritzt ist.

6. Gehäuse nach einem der vorhergehende Ansprüche, **dadurch gekennzeichnet, dass** das Gehäuse (22) abschnittsweise, insbesondere im Bereich der Halteabschnitte (32, 34), mit den Leitungsabschnitten (12, 16) verklebt ist.

7. Verfahren zur Herstellung eines Batteriesensors (10) nach einem der vorhergehenden Ansprüche, mit folgenden Schritten:
- Bereitstellen einer Baugruppe bestehend aus zumindest den Leitungsabschnitten (12, 16) und dem mit den Leitungsabschnitten (12, 16) elektrisch verbundenen Messwiderstand (20), wobei an zumindest einem Leitungsabschnitt (12, 16) zumindest ein Halteabschnitt (32, 34) vorgesehen ist,
- Verbinden der Baugruppe mit dem Gehäuse (22), wobei das Gehäuse (22) formschlüssig in die Halteabschnitte (32, 34) eingreift.

8. Verfahren nach Anspruch 7, **dadurch gekennzeichnet, dass** das Gehäuse (22) an die Baugruppe angespritzt wird, insbesondere aus Kunststoff.

9. Verfahren nach einem der Ansprüche 7 und 8, **dadurch gekennzeichnet, dass** der zumindest eine Halteabschnitt (32, 34) durch Umformen, insbesondere durch Prägen, hergestellt wird.
